# EUROPEAN PATENT APPLICATION

(11) **EP 4 250 275 A1**
(43) Date of publication of application: **27.09.2023**
(21) Application number: 21894673.9
(22) Date of filing: 17.11.2021
(51) Int. Cl.: G09F 9/30, H01L 27/32, G02B 5/20, H05B 33/04, H05B 33/12, H01L 51/50, H05B 33/22

(54) **ORGANIC EL DISPLAY DEVICE**

(30) Priority: 18.11.2020 JP 2020191587
(71) Applicant: TOPPAN INC., Tokyo 110-0016 (JP)
(72) Inventor: YAMAUCHI Atsushi, Tokyo 110-0016 (JP); NAGATOME Hiroki, Tokyo 110-0016 (JP)
(74) Representative: Hoffmann Eitle
(86) International application number: PCT/JP2021/042207
(87) International publication number: WO 2022/107799

(57) **Abstract**

An organic electroluminescent display device includes a light-emitting device substrate assembly and a color filter. The light-emitting device substrate assembly includes light-emitting devices at predetermined positions on a drive circuit board including a semiconductor substrate having a drive circuit formed therein. The color filter includes at least red colored pixels, green colored pixels, and blue colored pixels at positions corresponding to the light-emitting devices of the light-emitting device substrate assembly in plan view. In plan view, a light-shielding layer is disposed at a position that does not overlap the light-emitting devices, and straddles a boundary between the colored pixels. In cross-sectional view, the surface of the light-shielding layer oriented toward the light-emitting devices is flush with the surface of the color filter oriented toward the light-emitting devices or closer to the light-emitting devices than the surface of the color filter oriented toward the light-emitting devices is.

## Description

### [Technical Field]

The present invention relates to organic electroluminescent display devices and, more specifically, to organic electroluminescent display devices with improved color reproducibility.

The present application claims priority to earlier Japanese Patent Application No. 2020-191587 filed November 18, 2020, the entire contents of which are incorporated herein by reference.

### [Background Art]

Known organic electroluminescent display devices include large organic electroluminescent display devices, such as organic EL televisions, and small organic electroluminescent display devices used as head-mounted displays for virtual reality and others and display devices for smartphones.

Small organic electroluminescent display devices include a light-emitting device substrate assembly produced by forming organic electroluminescent light-emitting devices on a drive circuit board obtained by forming a drive circuit in a semiconductor substrate, such as a silicon wafer.

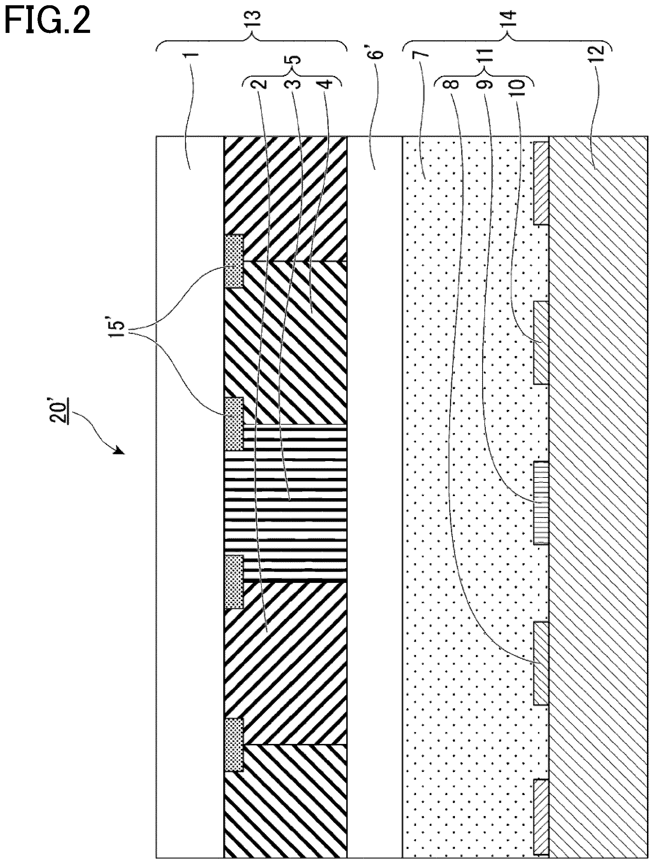

Fig. 2 illustrates the cross-sectional structure of a conventional small organic electroluminescent display device (refer to, for example, Patent Literature 1). An organic electroluminescent display device 20' includes a drive circuit board 12 obtained by forming a drive circuit in a semiconductor substrate, such as a silicon wafer. Light-emitting devices 11 including, for example, red light-emitting devices (red) 8, green light-emitting devices (green) 9, and blue light-emitting devices (blue) 10 are formed on regions of the drive circuit board 12 corresponding to respective emission colors. Since the light-emitting devices are deteriorated by, for example, moisture, a sealing layer 8 that prevents deterioration is formed to seal the light-emitting devices. This provides a light-emitting device substrate assembly 14.

A color filter 13 is used to correct the colors of the light-emitting devices. In fabricating the color filter substrate assembly 13, first, a light-shielding layer 15' is formed on a glass substrate 1. This is typically referred to as a black matrix. Regions for forming colored pixels are formed in the apertures defined by the light-shielding layer 15'. The light-shielding layer 15' blocks light at the boundary regions between adjacent colored pixels, so that unnecessary light is blocked and the contrast is improved.

A color filter 5 is formed by sequentially forming colored pixels (red) 2, colored pixels (green) 3, and colored pixels (blue) 4 using the black matrix (light-shielding layer 15') as a reference pattern. This provides the color filter substrate assembly 13.

The light-emitting device substrate assembly 14 and the color filter substrate assembly 13 obtained in the above manner are adhered to each other with a resin layer 6'. This provides the organic electroluminescent display device 20'. Note that, in adhering the light-emitting device substrate assembly 14 with the color filter substrate assembly 13, the light-emitting devices (red) 8, light-emitting devices (green) 9, and light-emitting devices (blue) 10 of the light-emitting device substrate assembly 14 are aligned with the colored pixels (red) 2, colored pixels (green) 3, and colored pixels (blue) 4 of the color filter substrate assembly 13 so that the same colors are aligned.

### [Citation List]

### [Patent Literature]

[PTL 1] JP 6019997 B

### [Summary of Invention]

### [Technical Problem]

As illustrated in Fig. 2, the conventional organic electroluminescent display device is unable to block oblique light emitted from the light-emitting devices 11 due to the existence of the sealing layer 7, the resin layer 6', and the color filter 5 between the light-emitting devices 11 of the light-emitting device substrate assembly 14 and the light-shielding layer 15'. For this reason, an organic electroluminescent display device with high color reproducibility has not been achieved.

In view of the above circumstances, the present invention aims at providing an organic electroluminescent display device with high color reproducibility by blocking oblique light emitted from light-emitting devices.

### [Solution to Problem]

One aspect of the present invention is an organic electroluminescent display device including a light-emitting device substrate assembly and a color filter. The light-emitting device substrate assembly includes light-emitting devices at predetermined positions on a drive circuit board including a semiconductor substrate having a drive circuit formed therein. The color filter includes at least red colored pixels, green colored pixels, and blue colored pixels at positions corresponding to the light-emitting devices of the light-emitting device substrate assembly in plan view.

According to the organic electroluminescent display device, in plan view, a light-shielding layer is disposed at a position that does not overlap the light-emitting devices, the light-shielding layer straddling a boundary between the colored pixels. Each of the light-shielding layer and the color filter has a surface oriented toward the light-emitting devices, and, in cross-sectional view, the surface of the light-shielding layer is flush with the surface of the color filter or closer to the light-emitting devices than the surface of the color filter is.

According to an example of the organic electroluminescent display device, the light-shielding layer includes an upper section, an intermediate section, and a lower section. The upper section has an upper surface that is a convex curved surface. The intermediate section is below the upper section and has a reverse tapered shape in which the intermediate section has a width that gradually decreases downward. The lower section is below the intermediate section and has a tapered shape in which the lower section has a width that gradually increases toward the light-emitting devices.

### [Advantageous Effects of Invention]

The present invention enables effectively blocking oblique light emitted from light-emitting devices and thus providing an organic electroluminescent display device with high color reproducibility.

### [Brief Description of Drawings]

Fig. 1 is a cross-sectional explanatory diagram illustrating an organic electroluminescent display device according to a first embodiment of the present invention.
Fig. 2 is a cross-sectional explanatory diagram illustrating a conventional organic electroluminescent display device.
Fig. 3 is a cross-sectional explanatory diagram illustrating an organic electroluminescent display device according to a second embodiment of the present invention.
Fig. 4 is a schematic cross-sectional view of part of a light-shielding layer according to the organic electroluminescent display device.
Fig. 5 is a schematic cross-sectional view of a modification of the organic electroluminescent display device.

### [Description of Embodiments]

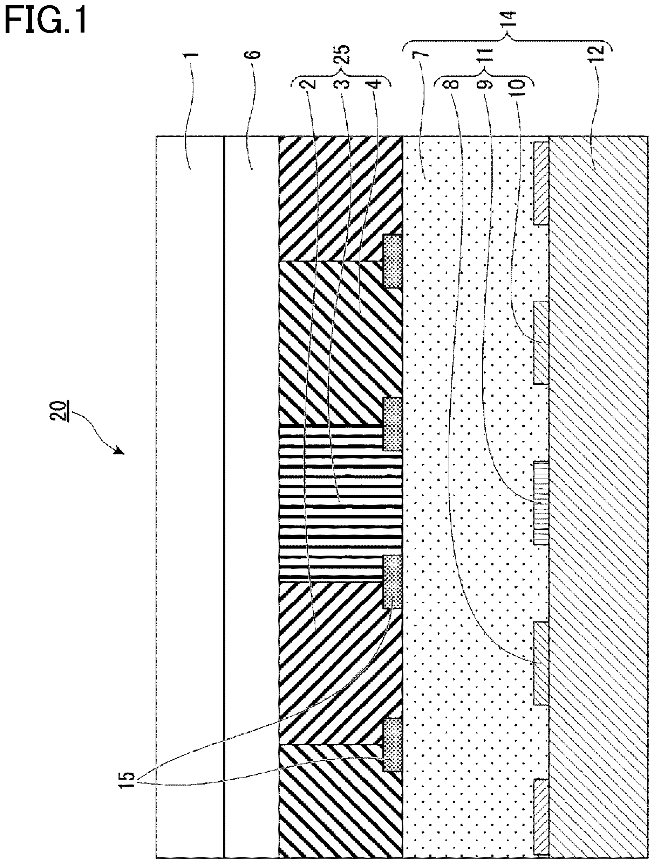

An organic electroluminescent display device according to a first embodiment of the present invention will be described with reference to Fig. 1.

An organic electroluminescent display device 20 of the present embodiment includes a light-emitting device substrate assembly and a color filter 25. The light-emitting device substrate assembly is obtained by forming light-emitting devices 11 at predetermined positions on a drive circuit board 12 obtained by forming a drive circuit in a semiconductor substrate. The color filter 25 includes at least red colored pixels (colored pixels (red) 2), green colored pixels (colored pixels (green) 3), and blue colored pixels (colored pixels (blue) 4) at positions corresponding to the associated light-emitting devices (light-emitting devices (red) 8, light-emitting devices (green) 9, and light-emitting devices (blue) 10) of the light-emitting device substrate assembly in plan view.

In the organic electroluminescent display device 20 of the present invention, a light-shielding layer 15 is formed to straddle the boundaries between adjacent colored pixels 2, 3, and 4 and at positions that do not overlap the light-emitting devices 8, 9, and 10 in plan view. In other words, the width of the light-shielding layer 15 is smaller than the distance between the adjacent light-emitting devices.

Furthermore, the surface of the light-shielding layer 15 oriented toward the light-emitting devices 11 is flush with the surface of the color filter 25 oriented toward the light-emitting devices 11 or is located closer to the light-emitting devices 11 than the surface of the color filter 25 oriented toward the light-emitting devices 11 is. In other words, the distance between the drive circuit board 12 and the surface of the light-shielding layer 15 oriented toward the light-emitting devices 11 is less than or equal to the distance between the drive circuit board 12 and the surface of the color filter 25 oriented toward the light-emitting devices 11.

For example, in the case in which a sealing layer 7, which protects the light-emitting devices 11 from, for example, moisture, is formed between the light-emitting devices 11 and the color filter 25, the light-shielding layer 15 may be formed on the surface of the sealing layer 7 oriented toward the color filter 25 or may be formed at such a position that the light-shielding layer 15 is embedded in the sealing layer 7 in the direction of the film thickness.

With the above configuration, the light emitted from each light-emitting device 11 in a direction orthogonal to the flat surface of the light-emitting device 11 is not blocked by the light-shielding layer 15, passes through the color filter 25, and emerges from the glass substrate 1. Furthermore, while the light-shielding layer 15' (refer to Fig. 2) is located on the surface of the color filter 5 oriented toward the glass substrate 1 (position further from the light-emitting devices 11 by the thickness of the color filter 5) in the conventional configuration, the light-shielding layer 15 is located on the surface of the color filter 25 oriented toward the light-emitting devices 11 in the configuration of the present invention. Thus, of the light emitted from the light-emitting devices (red) 8, light-emitting devices (green) 9, and light-emitting devices (blue) 10 of the light-emitting devices 11, a greater amount of light obliquely emitted from the light-emitting devices 11 is blocked by the light-shielding layer 15. That is, the above configuration inhibits mixing of colors between the adjacent pixels by blocking the oblique light that would become noise and thus maintains high color reproducibility.

Additionally, in the case in which the light-shielding layer 15 is formed at such a position that the light-shielding layer 15 is embedded in the sealing layer 7 in the direction of the film thickness, the light-shielding layer 15 is formed at a position even closer to the light-emitting devices 11 than the case in which the light-shielding layer 15 is formed on the surface of the sealing layer 7 (oriented toward the color filter 25). This enables blocking even more light that has been obliquely emitted. This is because the size of the light-shielding layer 15 as viewed from a point where, for example, one of the light-emitting devices (red) 8 of the light-emitting devices 11 exists is larger when the light-shielding layer 15 is located closer to the light-emitting device (red) 8 than when the light-shielding layer 15 is located farther from the light-emitting device (red) 8. Thus, forming the light-shielding layer 15 at a position closer to the light-emitting devices 11 enables blocking a greater amount of light that has been obliquely emitted.

A method for forming the light-shielding layer 15 at such a position that the light-shielding layer 15 is embedded in the sealing layer 7 in the direction of the film thickness includes, for example, forming the sealing layer 7 to be thinner than the final thickness first and in this state forming the light-shielding layer 15. Subsequently, the sealing layer 7 is further formed in such a manner that the light-shielding layer 15 is embedded in the sealing layer 7.

In this manner, since a greater amount of oblique light emitted from the light-emitting devices 11 is blocked, an organic electroluminescent display device with high color reproducibility is provided.

### (Glass Substrate)

The glass substrate 1 may be any substrate as long as the substrate is formed of colorless, transparent glass material and is chemically stable. For example, alkali-free glass available from multiple glass manufacturers may be suitably used. The alkali-free glass is advantageous in that since the content of an alkaline component in the alkali-free glass is 0.1% or less, adverse effect of the alkaline component on a semiconductor device is so small that it can be ignored or is virtually zero. Additionally, the alkali-free glass has a small coefficient of thermal expansion and good dimensional stability. Even when the alkali-free glass is exposed to a variety of chemicals during fabrication processes, no corrosion or change in properties occurs, and the alkali-free glass remains chemically stable. Furthermore, alkali-free glass without a component that pollutes the environment, such as heavy metal, may be selected.

### (Color Filter)

The colored pixel portions of the color filter 25 may be the same as the conventional structure. In particular, colored pixels formed by a photolithographic method may be suitably used. The photolithographic method includes steps of applying a photosensitive colored resin composition to a substrate, drying, exposing to light, and developing.

### (Light-Emitting Device)

The light-emitting devices 11 include at least the light-emitting devices (red) 8, which are red light-emitting devices, the light-emitting devices (green) 9, which are green light-emitting devices, and the light-emitting devices (blue) 10, which are blue light-emitting devices. This enables the display device to display in full color. In the organic electroluminescent display device 20 of the present invention, the light-emitting devices (red) 8, the light-emitting devices (green) 9, which are the green light-emitting devices, and the light-emitting devices (blue) 10, which are the blue light-emitting devices, are red organic light-emitting diodes (OLED), green OLEDs, and blue OLEDs, respectively. The OLEDs may be referred to as organic electroluminescent devices.

### (Drive Circuit Board)

The drive circuit board 12 includes a semiconductor substrate in which an OLED drive circuit and connection electrodes for connection to the OLEDs are formed. Specifically, the drive circuit board 12 is a substrate obtained by forming an OLED drive circuit in a silicon wafer.

The OLED drive circuit is different from a drive circuit of a liquid crystal display device. In the liquid crystal display device, individual pixels are regarded as capacitors. An image is displayed by a voltage holding circuit, which holds the voltage of the capacitors above or equal to a certain value for a frame period. In the OLED drive circuit, an image is displayed by a current holding circuit, which holds the current to be greater than or equal to a predetermined value for a frame period. While at least one transistor is used for one pixel in the voltage holding circuit used in the liquid crystal display device, at least two transistors are used for one pixel in the current holding circuit used in the organic electroluminescent display device.

### (Resin Layer)

The resin layer 6 is an adhesive layer or a pressure-sensitive adhesive layer for adhering the color filter 25 to the glass substrate 1.

The resin layer 6 may be any material as long as the material functions as the adhesive layer or the pressure-sensitive adhesive layer formed of a transparent resin.

Examples of adhesives include phenol resins, urea resins, melamine resins, solventless adhesives, solvent-based adhesives, and aqueous adhesives.

Examples of solventless adhesives include second-generation acrylic adhesives, epoxy adhesives, and hot-melt adhesives. Examples of hot-melt adhesives include ethylene-vinyl acetate copolymers (EVA) and urethane.

Examples of solvent-based adhesives include vinyl acetate adhesives and synthetic rubbers. Examples of synthetic rubbers include acrylic rubber and chloroprene rubber.

Examples of aqueous adhesives include vinyl acetate adhesives, EVA adhesives, and acrylic adhesives.

Among these adhesives, the material having properties excellent for optics applications such as transparency may be selected and used.

Known pressure-sensitive adhesives include solvent-based adhesives, emulsion adhesives, hot-melt adhesives, and curable liquid adhesives.

Like the adhesives, among these pressure-sensitive adhesives, materials having properties excellent for optics applications such as transparency may be selected and used.

### (Sealing Layer)

The sealing layer 7 is formed to prevent deterioration of the light-emitting devices 11, which are formed on the connection electrodes for the OLEDs formed at predetermined positions on the drive circuit board 12, due to, for example, moisture. This is because the organic semiconductor material constituting the light-emitting devices 11, which are OLEDs (organic electroluminescent devices), deteriorates due to, for example, moisture in the atmosphere.

The sealing layer 7 may be made of any material as long as the material is transparent and has the sealing function to the extent that it can prevent the deterioration of the OLEDs; inorganic material, organic material, or a combination of these may be used.

Examples of the inorganic material include silicon nitride (SiNₓ), silicon oxide, and metal oxide.

The organic material may be formed of a thermosetting resin or an ultraviolet curable resin.

### (Light-Shielding Layer)

The light-shielding layer 15 may be made of any material as long as a matrix pattern or a parallel line pattern with an optical density of 0.8 or more, a thickness of 1.5 µm or less, a line width of 1.0 µm or less, and a pitch of 2.4 µm or less can be formed so that light emitted from the light-emitting devices 11 is blocked.

For example, a metal thin film made of titanium, molybdenum, tantalum, or the like may be formed on the sealing layer 7, followed by forming a photosensitive resist pattern; then, patterning is performed by a dry etching method using a plasma etching device or a reactive ion etching device.

Alternatively, a black resist pattern may be formed by a photolithographic method using a photosensitive black resist.

Examples according to the first embodiment of the present invention will be described. The technical idea of the present invention is not limited in any way by the specifics of the examples.

### <Example 1>

### [Fabrication of OLED Device]

A silicon substrate (drive circuit board) was prepared in which a drive circuit was formed by front-end wafer processing. White electroluminescent devices were formed on the silicon substrate by a known method such as a vapor deposition method, followed by depositing silicon nitride by a chemical vapor deposition (CVD) method as a sealing layer, thereby forming an organic electroluminescent device substrate assembly (the light-emitting device substrate assembly 14 in Fig. 1).

Subsequently, colorant compositions were prepared in the following manner.

### [Preparation of Colorant Composition]

### (1) Black Colored Composition

Colorants used for the colorant composition were as follows.
Blue pigment: C. I. Pigment Blue 15:6
(LIONOL BLUE ES manufactured by TOYOCOLOR CO., LTD.)
Violet pigment: C. I. Pigment Violet 23
(LIONOGEN VIOLET RLj manufactured by TOYOCOLOR CO., LTD.)
Yellow pigment: C. I. Pigment Yellow 139
(PALIOTOL Yellow L 2146HDj manufactured by BASF)
A black colored resin composition was prepared using these pigments.

### - Black colorant

A mixture of the following composition was uniformly agitated and mixed, followed by dispersion for 5 hours by a sand mill using glass beads each having a diameter of 1 mm, which was further followed by filtering using a 5 µm filter, thereby preparing a dispersion of black pigment.

| | |
|---|---|
| Blue pigment: C. I. Pigment Blue 15:6 | 11 parts by weight |
| Violet pigment: C. I. Pigment Violet 23 | 11 parts by weight |
| Yellow pigment: C. I. Pigment Yellow 139 parts | 6 parts by weight |
| Acrylic varnish (solid content of 20%) | 170 parts by weight |

Subsequently, the mixture of the above composition was agitated and mixed to be uniform, followed by filtering using a 5 µm filter, thereby obtaining a black colorant (BLK-1).

A black photosensitive colorant composition (BLKR-1) was prepared using this colorant and other components (resin, monomer, initiator, chain transfer agent, and solvent) so that the formulation shown in Table 1 was achieved.

### (2) Red Colored Composition

Colorants used for the red colored composition were as follows.
Red pigment: C. I. Pigment Red 254
(Irgaphor Red B-CF Manufactured by BASF)
Yellow pigment: C. I. Pigment Yellow 139
(Paliotrol Yellow L 2146HD Manufactured by BASF)
A red colored resin composition was prepared using these pigments.

### - Red Colorant

A mixture of the following composition was uniformly agitated and mixed, followed by dispersion for 5 hours by a sand mill using glass beads each having a diameter of 1 mm, which was further followed by filtering using a filter of 5 µm, thereby preparing a dispersion of red pigment.

| | |
|---|---|
| Red pigment: C. I. Pigment Red 254 | 78 parts by weight |
| Yellow pigment: C. I. Pigment Yellow 139 | 22 parts by weight |
| Acrylic varnish (solid content of 20%) | 215 parts by weight |

Subsequently, the mixture of the above composition was agitated and mixed to be uniform, followed by filtering using a 5 µm filter, thereby obtaining a red colorant (R-1).

A red photosensitive colorant composition (RR-1) was prepared using this colorant and other components (resin, monomer, initiator, chain transfer agent, and solvent) so that the formulation shown in Table 1 was achieved.

### (3) Green Colored Composition

Colorants used for the red colored composition were as follows.
Green pigment: C. I. Pigment Green 58
(FASTOGEN GREEN A110 manufactured by DIC Corporation)
Yellow pigment: C. I. Pigment Yellow 185
(Paliotrol Yellow L1155 manufactured by BASF)
A green colored resin composition was prepared using these pigments.

### - Green Colorant

A mixture of the following composition was uniformly agitated and mixed, followed by dispersion for 5 hours by a sand mill using glass beads each having a diameter of 1 mm, which was further followed by filtering using a 5 µm filter, thereby preparing a dispersion of green pigment.

| | |
|---|---|
| Green pigment: C. I. Pigment Green 58 | 65 parts by weight |
| Yellow pigment: C. I. Pigment Yellow 185 | 35 parts by weight |
| Acrylic varnish (solid content of 20%) | 215 parts by weight |

Subsequently, the mixture of the above composition was agitated and mixed to be uniform, followed by filtering using a 5 µm filter, thereby obtaining a green colorant (G-1).

A green photosensitive colorant composition (GR-1) was prepared using this colorant and other components (resin, monomer, initiator, chain transfer agent, and solvent) so that the formulation shown in Table 1 was achieved.

### (4) Blue Colored Composition

Colorants used for the blue colored composition were as follows.
Blue pigment: C. I. Pigment Blue 15:6
(LIONOL BLUE ES manufactured by TOYOCOLOR CO., LTD.)
Violet pigment: C. I. Pigment Violet 23
(LIONOGEN VIOLET RLj manufactured by TOYOCOLOR CO., LTD.)
A blue colored resin composition was prepared using these pigments.

### - Blue Colorant

A mixture of the following composition was uniformly agitated and mixed, followed by dispersion for 5 hours by a sand mill using glass beads each having a diameter of 1 mm, which was further followed by filtering using a 5 µm filter, thereby preparing a dispersion of blue pigment.

| | |
|---|---|
| Blue pigment: C. I. Pigment Blue 15:6 | 63 parts by weight |
| Violet pigment: C. I. Pigment Violet 23 | 37 parts by weight |
| Acrylic varnish (solid content of 20%) | 215 parts by weight |

Subsequently, the mixture of the above composition was agitated and mixed to be uniform, followed by filtering using a 5 µm filter, thereby obtaining a blue colorant (B-1).

A blue photosensitive colorant composition (BR-1) was prepared using this colorant and other components (resin, monomer, initiator, chain transfer agent, and solvent) so that the formulation shown in Table 1 was achieved.

**[Table 1]**

| | BLKR-1 | RR-1 | GR-1 | BR-1 | |
|---|---|---|---|---|---|
| Colorant concentration | 50% | 45% | 45% | 45% | |
| Solid content | | 20% | 20% | 20% | 20% |
| Resist composition | Colornt | BLK-1 | R-1 | G-1 | B-1 |
| | | 65.00 | 64.29 | 64.29 | 57.14 |
| | Resin | 4.50 | 5.54 | 5.54 | 8.92 |
| | Monomer | 4.00 | 4.00 | 4.00 | 4.00 |
| | Initiator | 0.60 | 0.60 | 0.60 | 0.60 |
| | Chain transfer agent | 0.00 | 0.20 | 0.20 | 0.20 |
| | Solvent | 20.50 | 25.06 | 25.06 | 29.14 |
| | Total | 94.60 | 99.69 | 99.69 | 100.0 |

### [Preparation of Color Filter and Organic Electroluminescent Display Device]

A transparent resin composition for use as a planarization film was applied to the sealing layer of the prepared organic electroluminescent device substrate assembly with a spinner so that the film thickness after being cured was 0.1 µm. This was subsequently heated at 100°C for 10 minutes using a heating oven for curing, thereby forming a planarization film (not shown in Fig. 1).

Next, the black photosensitive resin composition was applied to the planarization film with the spinner so that the film thickness after being cured was 0.5 µm, which was subjected to exposure to ultraviolet light via a photomask having a desired pattern and alkaline developing, rinsing, and drying steps, thereby being temporarily formed to cover sections where the OLED devices do not illuminate (or non-light-emitting sections). This was subsequently heated at 80°C for 10 minutes using a heating oven for curing, thereby forming the light-shielding layer (or black matrix (BM)).

Next, the green photosensitive resin composition was applied to the light-shielding layer with the spinner so that the film thickness after being cured was 1.0 µm, which was subjected to exposure to ultraviolet light via a photomask having a desired pattern and alkaline developing, rinsing, and drying steps, thereby temporarily forming a green layer (G) having a pixel size of 2.4 µm × 2.4 µm. This was subsequently heated at 80°C for 10 minutes using a heating oven for curing, thereby forming the green layer (G).

Next, like the formation of the green layer (G), the red photosensitive resin composition was applied with the spinner so that the film thickness after being cured was 1.0 µm, which was subjected to exposure to ultraviolet light via a photomask having a desired pattern and alkaline developing, rinsing, and drying steps, thereby temporarily forming a red layer (R) having a pixel size of 2.4 µm × 2.4 µm. This was subsequently heated at 80°C for 10 minutes using a heating oven for curing, thereby forming the red layer (G).

Next, like the formation of the green layer (G), the red photosensitive resin composition was applied with the spinner so that the film thickness after being cured was 1.0 µm, which was subjected to exposure to ultraviolet light via a photomask having a desired pattern and alkaline developing, rinsing, and drying steps, thereby temporarily forming a blue layer (B) having a pixel size of 2.4 µm × 2.4 µm. This was subsequently heated at 80°C for 10 minutes using a heating oven for curing, thereby forming the blue layer (B). This completes the formation of the color filter.

Furthermore, a cover glass was adhered to the color filter using a sealant, STRUCTBOND XMF-T-107 (manufactured by Sumitomo Chemical Co., Ltd.), to prepare the organic electroluminescent display device.

### <Comparative Example 1>

An organic electroluminescent display device was prepared in the same manner as Example 1 except that the light-shielding layer was not formed, and the thickness of the red layer, the green layer, and the blue layer of the color filter was set to 1.2 µm.

### <Evaluation of Color Reproducibility>

The organic electroluminescent display devices prepared in Example 1 and Comparative Example 1 were placed next to each other, and the brightness of the red color, the green color, and the blue color was visually compared when these display devices were caused to simultaneously display only the red color, the green color, or the blue color. As a result, the red color, the green color, and the blue color of the organic electroluminescent display device prepared in Example 1 were obviously brighter. Thus, the organic electroluminescent display device prepared in Example 1 was found to be superior in the color reproducibility. This is probably because forming the light-shielding layer closer to the light-emitting devices allowed, among the light emitted from the light-emitting devices, a greater amount of light that had been obliquely emitted to be blocked, reduced light that passed through the adjacent pixels, and thus inhibited the mixing of colors.

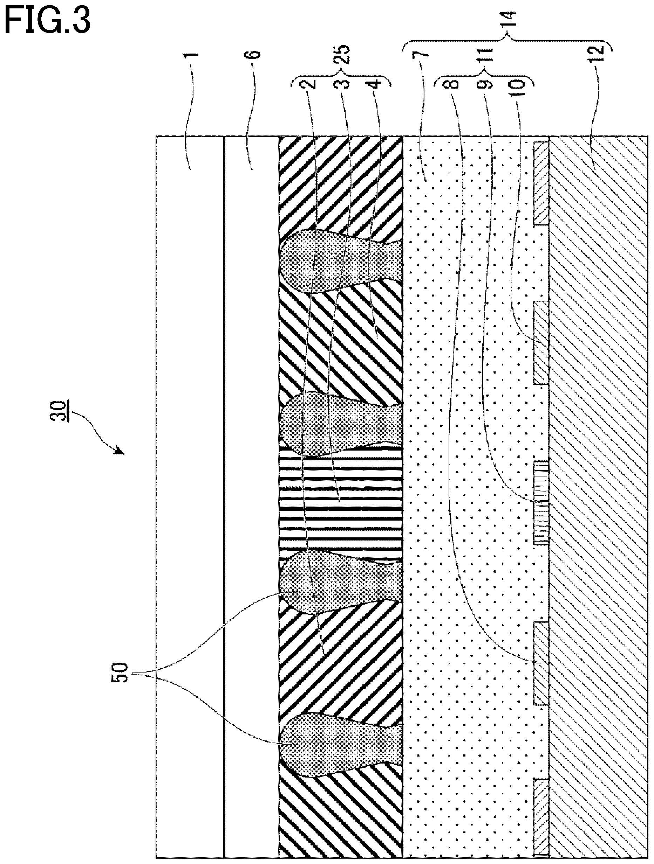

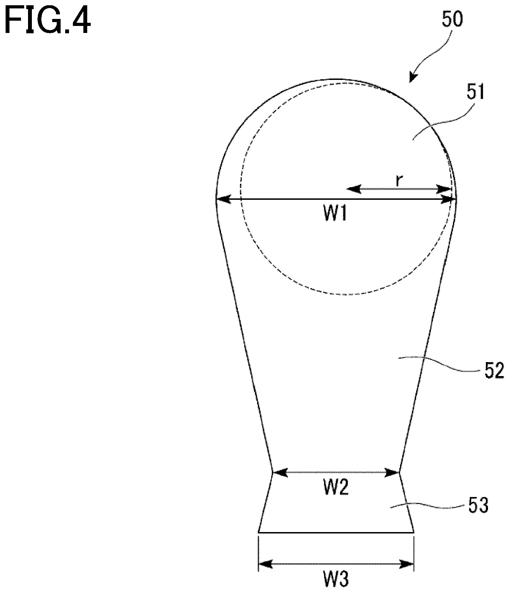

A second embodiment of the present invention will now be described with reference to Figs. 3 and 4. In the following description, components that are common to those described above are denoted by the same reference signs, and duplicated description thereof will be omitted.

Fig. 3 is a schematic cross-sectional view of an organic electroluminescent display device 30 according to the present embodiment. The organic electroluminescent display device 30 differs from the first embodiment only in that a light-shielding layer 50 is included instead of the light-shielding layer 15. The shape of the light-shielding layer 50 in plan view is substantially the same as that of the light-shielding layer 15, but the shape greatly differs in the cross-section (cross-section in a width direction) orthogonal to the direction in which the light-shielding layer 50 extends.

Fig. 4 illustrates the cross-section of a part of the light-shielding layer 50 with the cross-sectional shape enlarged. The light-shielding layer 50 includes a lower section 53, an intermediate section 52, and an upper section 51 from the side closer to the sealing layer 7.

The upper surface of the upper section 51 in the cross-sectional shape is curved in such a manner that the middle part in the width direction is the highest and is, more specifically, substantially hemispherical.

The intermediate section 52 of the cross-sectional shape is tapered to have a shape in which the width gradually decreases from the boundary between the upper section 51 and the intermediate section 52 toward the lower section 53 (hereinafter, referred to as "reverse tapered shape").

The lower section 53 of the cross-sectional shape is tapered to have a shape in which the width gradually increases from the boundary between the intermediate section 52 and the lower section 53 toward the sealing layer 7 (hereinafter, referred to as "tapered shape").

The width dimension of the intermediate section 52 is the greatest at the part connected to the upper section 51, and its value W1 (the maximum width of the intermediate section, the maximum width of the upper section) is substantially the same as the maximum width dimension of the upper section 51.

The width dimension of the intermediate section 52 is the smallest at the part connected to the lower section 53, and its value W2 (the minimum width of the intermediate section) is substantially the same as the minimum width dimension of the lower section 53.

The width dimension of the lower section 53 is the greatest at the lower end part that is in contact with the sealing layer 7, and its value W3 (the maximum width of the lower section) is smaller than the value W1.

The organic electroluminescent display device 30 of the present embodiment effectively blocks light obliquely emitted from the light-emitting devices in the same manner as in the first embodiment. Furthermore, the following operational advantages are achieved with the light-shielding layer 50 having the above configuration.

First, since the upper surface of the upper section 51 is a convex curved surface in the cross-sectional shape, in applying the colored resin composition, which will serve as the color filter 25, after the formation of the light-shielding layer 50, the colored resin composition is inhibited from remaining on the light-shielding layer 50, and the liquid composition flows through the apertures of the light-shielding layer in a suitable manner. As a result, the ease of application of the colored resin composition is improved.

Next, since the intermediate section 52 has a reverse tapered shape, and the maximum width dimension W3 of the lower section 53 is smaller than the value W1, the size of the apertures in the light-shielding layer is increased on the lower side close to the light-emitting devices. As a result, a greater amount of light from the light-emitting devices is introduced into the color filter 25, which improves the light extraction efficiency.

Furthermore, since the lower section 53 has a tapered shape, the area in contact with the sealing layer 7 is increased compared with a straight-shaped lower section in which the dimension in the width direction does not change. As a result, the structure improves the adhesion to the sealing layer 7 and inhibits, for example, separation from the sealing layer 7 in a suitable manner.

The light-shielding layer 50 is easily prepared by using a black photoreactive resist.

First, the photoreactive resist is applied to the sealing layer 7 to form a resist layer.

Next, the resist layer is exposed to light using a mask patterned to correspond to the shape of the light-shielding layer 50 in plan view. At this time, the central portion of each mask aperture is more intensely irradiated with light (for example, the i-line with a wavelength of 365 nm) for curing the resist, than the peripheral portion of the mask aperture. As a result, while the resist sufficiently cures at the central portion of the mask aperture, the degree of effect is a little weaker at the peripheral portion. When the resist layer undergoes a development step, relatively large parts of the upper surface of the resist layer are removed in the vicinity of the peripheral portion of each mask aperture, resulting in making the upper surface of the upper section 51 a convex spherical surface.

Since the resist is black, the smaller amount of light reaches the lower part of the resist layer than the upper part thereof. Because of this and the fact that the light is more intense at the central portion than the peripheral portion, the dimension of the intermediate section in the width direction is gradually decreased toward the lower end. As a result, the intermediate section 52 has a reverse tapered shape. Additionally, in the developing step, due to, for example, the surface tension of the developer, the developer does not sufficiently reach the vicinity of the lower end of the light-shielding layer. As a result, the lower section 53 has a tapered shape.

The light-shielding layer 50 is fabricated by the above procedure. A post baking process may be performed as necessary. A suitable example of the above-mentioned black photoreactive resist includes the photosensitive colorant composition disclosed in Japanese Laid-Open Patent Publication No. 2020-71433. Since this composition cures at a relatively low temperature of 100°C or less, even when the light-shielding layer is directly formed on a layer that seals the OLEDs as in the present embodiment, the post baking process can be performed causing little or no damage to the OLEDs located below.

To suitably exhibit the variety of advantages mentioned above, it is effective to make the light-shielding layer have a predetermined cross-sectional shape.

In regard to the advantage achieved by the upper section 51, the radius of curvature r (refer to Fig. 4) of the upper surface of the upper section 51 is preferably 0.3 to 0.6 times the value W1.

In regard to the advantage achieved by the intermediate section 52, the value W2 is preferably 0.4 to 0.6 times the value W1.

In regard to the advantage achieved by the lower section 53, the value W3 is preferably 0.5 to 0.7 times the value W1 and greater than the value W2.

Examples according to the second embodiment will be described.

### (Example 2)

Using BLKR-1 that is the same as in Example 1, exposure and development were performed under different conditions to prepare the light-shielding layer having the upper section, the intermediate section, and the lower section. Other structures were identical to those in Example 1, and an organic electroluminescent display device according to Example 2 was prepared.

The organic electroluminescent display device according to Example 2 was cut to show the cross-section of the light-shielding layer in the width direction, which was photographed by a scanning electron microscope (SEM). Using the obtained images, the dimensions of parts of the cross-sectional shape of the light-shielding layer were measured as follows.
- The radius of curvature r of the upper surface of the upper section was 0.33 to 0.53 times the value W1.
- The value W2 was 0.47 to 0.53 times the value W1.
The value W3 was 0.59 to 0.69 times the value W1.

As described above, it was confirmed that the light-shielding layer according to the second embodiment can be actually fabricated.

While the embodiments and the examples of the present invention have been described, the specific configurations are not limited to the above embodiments. Various modifications and combinations of the configurations can be made without departing from the principle of the present invention. Although some modifications will be shown below, these are not intended to represent all of the modifications, and other modifications are also possible. Two or more of these modifications may be combined as appropriate.

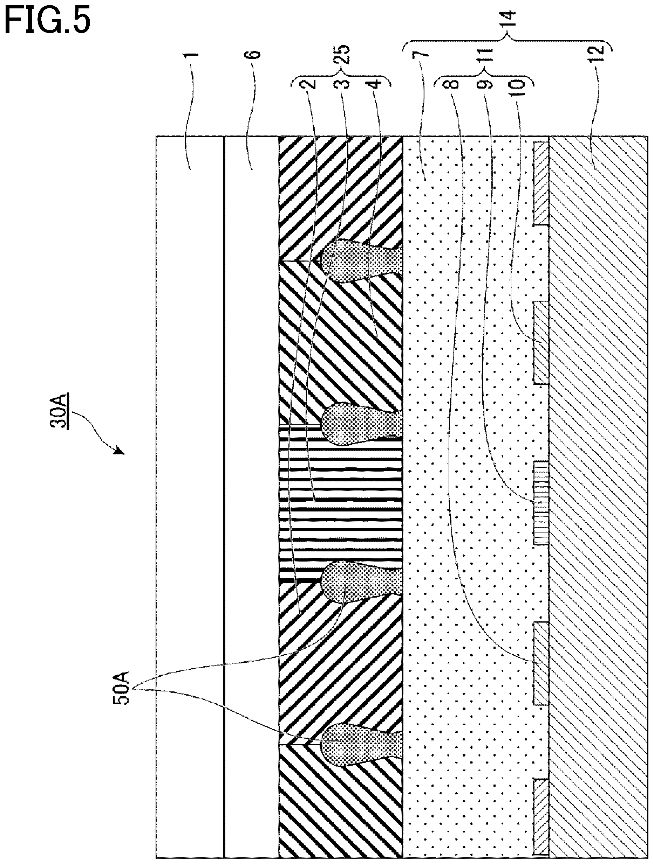

- Fig. 3 illustrates an example in which the top of the light-shielding layer and the top of the color filter are at a similar height, but this structure is not essential. Any structure may be employed as long as the surface of the light-shielding layer oriented toward the light-emitting devices is flush with the surface of the color filter oriented toward the light-emitting devices or closer to the light-emitting devices than the surface of the color filter oriented toward the light-emitting devices is. For this reason, like an organic electroluminescent display device 30A according to the modification shown in Fig. 5, a light-shielding layer 50A thinner than the color filter 25 may be provided.
- The light-shielding layer and the color filter according to the present embodiment are not limited to those directly formed on the light-emitting device substrate assembly as in the above-described embodiment. For example, a base made of, for example, a resin film may be prepared, and a light-shielding layer and colored pixels may be provided on this base. Such a color filter substrate assembly may be joined with a light-emitting device substrate assembly using, for example, an adhesive, which may then be used as a component of a display device other than the organic electroluminescent display device. In this case, with the light-shielding layer extending all the way along the thickness of the color filter, the oblique light is blocked in substantially the same manner whichever of the upper side and the lower side of the light-shielding layer is oriented toward a light source. Since no light-emitting device is located in the vicinity of the color filter substrate assembly during a fabrication process, the light-shielding layer may be formed of a black resist that is subjected to post baking at a high temperature without any problem.

### [Reference Signs List]

- 1: Glass substrate
- 2: Colored pixel (red) (red colored pixel)
- 3: Colored pixel (green) (green colored pixel)
- 4: Colored pixel (blue) (blue colored pixel)
- 6: Resin layer
- 7: Sealing layer
- 8: Light-emitting device (red)
- 9: Light-emitting device (green)
- 10: Light-emitting device (blue)
- 11: Light-emitting device
- 12: Drive circuit board
- 13: Color filter substrate assembly
- 14: Light-emitting device substrate assembly
- 15, 50, 50A: Light-shielding layer
- 20, 30, 30A: ORGANIC ELECTROLUMINESCENT DISPLAY DEVICE
- 25: Color filter

## Claims

1. An organic electroluminescent display device comprising:
a light-emitting device substrate assembly including a drive circuit board and light-emitting devices at predetermined positions on the drive circuit board, the drive circuit board including a semiconductor substrate having a drive circuit formed therein; and
a color filter including at least red colored pixels, green colored pixels, and blue colored pixels at positions corresponding to the light-emitting devices of the light-emitting device substrate assembly in plan view, wherein:
in plan view, a light-shielding layer is disposed at a position that does not overlap the light-emitting devices, the light-shielding layer straddling a boundary between the colored pixels; and
each of the light-shielding layer and the color filter has a surface oriented toward the light-emitting devices, and, in cross-sectional view, the surface of the light-shielding layer is flush with the surface of the color filter or closer to the light-emitting devices than the surface of the color filter is.

2. The organic electroluminescent display device according to claim 1, wherein:
the light-shielding layer has an upper surface in a cross-section in a width direction of the light-shielding layer, and the upper surface is a convex curved surface.

3. The organic electroluminescent display device according to claim 1, wherein:
the light-shielding layer includes a vertically intermediate section in a cross-section in a width direction of the light-shielding layer; and
the intermediate section has a reverse tapered shape in which the intermediate section has a width that gradually decreases downward.

4. The organic electroluminescent display device according to claim 1, wherein:
the light-shielding layer includes, in a cross-section in a width direction of the light-shielding layer, a lower end section facing the light-emitting devices; and
the lower end section has a tapered shape in which the lower end section has a width that gradually increases toward the light-emitting devices.

5. The organic electroluminescent display device according to claim 1, wherein the light-shielding layer includes:
an upper section having an upper surface that is a convex curved surface;
an intermediate section below the upper section, the intermediate section having a reverse tapered shape in which the intermediate section has a width that gradually decreases downward; and
a lower section below the intermediate section, the lower section having a tapered shape in which the lower section has a width that gradually increases toward the light-emitting devices.

6. The organic electroluminescent display device according to claim 5, wherein:
the curved surface has a radius of curvature of 0.3 or more and 0.6 or less times a maximum dimension of the intermediate section in a width direction.

7. The organic electroluminescent display device according to claim 5, wherein:
the intermediate section has a minimum width of 0.4 or more and 0.6 or less times a maximum width of the intermediate section.

8. The organic electroluminescent display device according to claim 5, wherein:
the lower section has a maximum width smaller than a maximum width of the upper section.

9. The organic electroluminescent display device according to claim 8, wherein:
the maximum width of the lower section is 0.5 or more and 0.7 or less times the maximum width of the upper section.

10. The organic electroluminescent display device according to claim 1, further comprising:
a sealing layer between the light-emitting devices and the color filter,
part of the light-shielding layer being embedded in the sealing layer.
